# EUROPÄISCHE PATENTSCHRIFT

(11) **EP 3 472 936 B1**
(45) Veröffentlichungstag und Bekanntmachung des Hinweises auf die Patenterteilung: **08.07.2020**
(21) Anmeldenummer: 17732850.7
(22) Anmeldetag: 16.06.2017
(51) Int. Cl.: H03K 17/96

(54) **EINRICHTUNG MIT MINDESTENS EINEM BELEUCHTBAREN BEREICH**
DEVICE HAVING AT LEAST ONE REGION THAT CAN BE ILLUMINATED
DISPOSITIF COMPORTANT AU MOINS UNE ZONE POUVANT ÊTRE ÉCLAIRÉE

(30) Priorität: 21.06.2016 DE 102016111350
(43) Veröffentlichungstag der Anmeldung: 24.04.2019
(73) Patentinhaber: Dr. Schneider Kunststoffwerke GmbH, 96317 Kronach Bayern (DE)
(72) Erfinder: ENDRES, Gerhard, 95336 Mainleus Bayern (DE); SCHINZLER, Claus, 96317 Kronach Bayern (DE)
(86) Internationale Anmeldenummer: PCT/EP2017/064822
(87) Internationale Veröffentlichungsnummer: WO 2017/220450

(56) Entgegenhaltungen:
- EP-A1- 1 985 930
- EP-A1- 2 690 786
- US-A1- 2013 248 344

## Beschreibung

Es wird eine Einrichtung mit mindestens einem beleuchtbaren Bereich beschrieben. Solche beleuchtbaren Einrichtungen sind bspw. für Fahrzeuge bekannt und ermöglichen es Symbole zu beleuchten, die bspw. verschiedene Schaltstellungen eines Bedienelements anzeigen.

Aus dem Stand der Technik ist es bekannt, eine Blende über Leuchtmittel von unten zu beleuchten. Hierzu muss die Blende entsprechende Aussparungen für die Leuchtmittel aufweisen und es sind Vorkehrungen zu treffen, damit das über ein Leuchtmittel eingebrachte Licht nicht andere Bereiche beleuchtet, welche nicht durch das entsprechende Leuchtmittel beleuchtet werden sollen.

Weiter ist es aus dem Stand der Technik bekannt, sogenannte Hohlreflektoren vorzusehen, über welche eine Beleuchtung erreicht wird.

DE 10 2014 009 199 A1 offenbart ein Montageelement zum Einbau in eine in einem Panel eines Luftfahrzeugs vorgesehene Einbauöffnung, mit einem zur Einbauöffnung korrespondierenden Einbaurahmen, in welchem zumindest ein Funktionselement gehalten ist, wobei der Einbaurahmen eine zur Kontur eines Umfangsrands des Einbaurahmens korrespondierende, aus einem transparenten Kunststoff hergestellten Lichtauskopplungsabschnitt mit einer Lichtauskopplungsfläche aufweist. An einer der Lichtauskopplungsfläche gegenüberliegenden Lichteinkopplungsfläche sind ein Hohlreflektor und zumindest eine LED vorgesehen, wobei die LED bezüglich der Lichteinkopplungsfläche so angeordnet ist, dass mit der LED erzeugtes Licht ausschließlich durch Reflexion am Hohlreflektor auf die Lichteinkopplungsfläche einstrahlbar ist.

Das in DE 10 2014 009 199 A1 offenbarte Montageelement weist jedoch Nachteile auf. Das Montageelement kann zwar mit einem Bedienelement versehen sein, jedoch wird durch das Bedienelement zusätzlicher Platz benötigt und aufgrund des benötigten Platzes die Beleuchtung eingeschränkt.

US 2013/0248344 A1 offenbart eine beleuchtbare, berührungsempfindliche Benutzerschnittstelle mit einer Blende mit einem beleuchtbaren Bereich, einer Leiterplatte mit einer Öffnung und einem kapazitiven Element, und einem Reflektor, wobei ein Leuchtmittel an der Rückseite der Leiterplatte angeordnet ist, so dass über den Reflektor eine Beleuchtung erfolgen kann.

EP 2 690 786 A1 offenbart ein Steuerungsgerät mit einem beleuchtbaren Bereich und einer Leiterplatte, an dessen Rückseite ein Leuchtmittel angeordnet ist, so dass über einen Reflektor und eine Öffnung in der Leiterplatte eine Beleuchtung erfolgen kann.

EP 1 985 930 A1 offenbart ein ähnlich aufgebautes Steuerungsgerät.

Es ist daher Aufgabe eine Einrichtung mit mindestens einem beleuchtbaren Bereich und einer Bedieneinrichtung anzugeben, welche die Nachteile des Stands der Technik behebt und einen einfachen Aufbau aufweist.

Die Aufgabe wird durch eine Einrichtung mit den in Anspruch 1 angegebenen technischen Merkmalen gelöst. Vorteilhafte Weiterbildungen sind in den Unteransprüchen im Detail angegeben.

Bei einer die vorstehende Aufgabe lösenden Einrichtung mit mindestens einem beleuchtbaren Bereich und einer Bedieneinrichtung, aufweisend eine Blende, eine Leiterplatte, mindestens ein Leuchtmittel und mindestens ein Reflektorelement,
- weist die Blende mindestens einen beleuchtbaren Bereich auf,
- weist die Leiterplatte mindestens ein Leuchtmittel auf, das benachbart zu einer Öffnung in der Leiterplatte angeordnet ist,
- ist die Blende so zu der Leiterplatte angeordnet, dass der mindestens eine beleuchtbare Bereich über einer Öffnung in der Leiterplatte angeordnet ist,
- ist das mindestens eine Leuchtmittel an der der Blende abgewandten Seite an der Leiterplatte angeordnet,
- ist ein Reflektorelement derart angeordnet, dass das von dem mindestens einen Leuchtmittel ausgegebene Licht zu der Öffnung und dem darüber liegenden beleuchtbaren Bereich reflektiert wird,
- weist die Bedieneinrichtung mindestens ein in der Leiterplatte integriertes Sensorelement auf,
- weist die Einrichtung eine Reflektorplatte mit mehreren Reflektorelementen auf, die durch Vertiefungen in der Reflektorplatte gebildet sind, und
- unterscheiden sich Form und Abmaße mindestens zweier Reflektorelemente.

Um die Nachteile des Stands der Technik zu beheben, wird vorgeschlagen, die Bedieneinrichtung durch Sensorelemente zu realisieren, die in der Leiterplatte integriert sind bzw. solche Sensorelemente für die Bedieneinrichtung zu verwenden. Die Bedieneinrichtung weist demgemäß keine relativ großen und störenden Bedienelemente, wie Taster, Drehsteller, Schalter etc., auf sondern ist zumindest teilweise in der Leiterplatte integriert. Hierdurch ist es möglich eine vollflächige Beleuchtung bei einer Schaltfunktion zu realisieren. Die Sensorelemente können auf der Oberseite der Leiterplatte angeordnet sein. Sie sind dabei auf der dem mindestens einen Leuchtmittel gegenüberliegenden Seite der Leiterplatte angeordnet.

Sensorelemente können kapazitive Sensoren, optische Sensoren oder Ultraschallsensoren sein. Optische Sensoren umfassen bspw. auch IR-Sensoren. Bei optischen Sensoren ist die Blende so ausgebildet, dass ein Ausgeben und Empfangen von Lichtstrahlen möglich ist. Hierzu ist die Blende mindestens bereichsweise transparent. Eine zumindest teilweise transparente Ausbildung der Blende ist ohnehin für die Beleuchtung erforderlich. Bei Ultraschallsensoren ist die Blende ebenfalls so auszuwählen bzw. auszubilden, dass ein Aussenden und Empfangen der Schallwellen möglich ist.

Bspw. kann ein kapazitiver Sensor um eine Öffnung in der Leiterplatte herum angeordnet sein. Über das der Öffnung zugeordnete Leuchtmittel wird die Blende in diesem Bereich beleuchtet, wobei die Blende zusätzlich ein Symbol aufweisen kann. Das Symbol repräsentiert eine Funktion und kann bspw. in der Blende durch einen Bereich gebildet sein, der anders gefärbt ist und/oder eine gegenüber dem restlichen Bereich der Blende eine geringere Tiefe aufweist. Über das Leuchtmittel wird das Symbol beleuchtet und ist daher auch nachts oder bei schlechten Lichtverhältnissen gut sichtbar. Berührt nun ein Benutzer den Bereich der Blende mit dem Symbol wird dies über den kapazitiven Sensor erfasst und es erfolgt - in Abhängigkeit der Ausbildung des kapazitiven Sensors und nach Maßgabe der Berührungsdauer und ggf. Berührungsstärke - eine damit in Verbindung stehende Aktion.

Über die an der Unterseite der Leiterplatte angeordneten Leuchtmittel, wobei die Leuchtmittel Licht nach unten, der Blende und dessen mindestens einem beleuchtbaren Bereich abgewandt, ausgeben, erfolgt eine vollflächige Ausleuchtung eines Bedienfelds. Das Bedienfeld ist der Bereich mit dem Symbol, wobei unterhalb und das Symbol umgebend bspw. ein kapazitiver Sensor angeordnet ist. Die Leiterplatte weist ferner eine Öffnung auf, in dessen Nähe das Leuchtmittel angeordnet ist, wobei die Öffnung unterhalb eines beleuchtbaren Bereichs der mindestens bereichsweise durchleuchtbaren Blende angeordnet ist. Unterhalb der Öffnung ist ein Reflektorelement angeordnet, welches das von dem Leuchtmittel ausgegebene Licht reflektiert. Das reflektierte Licht gelangt durch die Öffnung in der Leiterplatte zu dem beleuchtbaren Bereich und bewirkt damit eine Beleuchtung.

Über die an der Leiterplatte angeordneten Sensorelemente wird eine Einrichtung mit beleuchtbaren Steuerelementen bzw. Schaltelementen bereitgestellt, wobei zusätzlich auf eine spezielle Folie mit kapazitiven Elementen verzichtet werden kann. Hierdurch wird der Aufbau der Einrichtung wesentlich vereinfacht (keine Ausrichtung einer Folie zu Öffnungen und Beleuchtungseinrichtungen) und die Kosten gesenkt.

Die Einrichtung weist zusätzlich die Reflektorplatte mit mehreren Reflektorelementen auf, die durch Vertiefungen in der Reflektorplatte gebildet sind. Die Reflektorplatte kann bspw. aus Kunststoff bestehen und ist daher einfach herzustellen. Für eine Reflexion werden die Bereiche mit den Reflektorelementen beschichtet. Die Form und die Abmaße der einzelnen Reflektorelemente kann beliebig gewählt werden. Zudem ist es durch spezielle Gestaltungen der Reflektorelemente möglich, die Beleuchtung anzupassen. In der Regel soll eine homogene Beleuchtung erreicht werden. Es ist aber auch möglich, bestimmte Bereiche stärker oder schwächer zu beleuchten, wenn die Lichtstrahlen von dem Leuchtmittel gezielt abgelenkt und/oder gedämpft werden.

Das mindestens eine Reflektorelement kann so ausgebildet sein, dass es einen Boden und den Boden umgebende Seitenwände aufweist, wobei die oberen Enden der Seitenwände an der Leiterplatte anliegen.

Die oberen Seitenwände des mindestens einen Reflektorelements können die mindestens eine Öffnung in der Leiterplatte und mindestens das mindestens eine der Öffnung zugehörige Leuchtmittel umgeben.

Die Ausbildung und Anordnung des Reflektorelements ermöglichen es eine homogene Beleuchtung bereitzustellen, ohne dass es zu einem Lichtaustritt und damit Störlicht für andere zu beleuchtende Bereiche kommt.

Das mindestens eine Reflektorelement kann aus einem reflektierenden Material bestehen und/oder eine reflektierende Oberfläche und/oder eine reflektierende Beschichtung aufweisen.

Der mindestens eine beleuchtbare Bereich kann ein Symbol oder Zeichen aufweisen. Das Zeichen und das Symbol sind repräsentativ für damit gekoppelte Funktionen.

Das mindestens eine Reflektorelement oder die Reflektorplatte können wie vorstehend beschrieben aus Kunststoff oder Metall bestehen.

Ferner kann das mindestens eine Reflektorelement im Wesentlichen schalenförmig, topfförmig, wannenförmig oder rinnenförmig ausgebildet sein.

Das mindestens eine Sensorelement ist vorzugsweise im Bereich einer Öffnung in der Leiterplatte angeordnet und kann weiterhin die Öffnung vollständig umgeben.

Das Leuchtmittel kann eine lichtemittierende Diode und/oder ein Leuchtkörper sein. Ein Leuchtkörper kann bspw. ein Lichtleiter sein, der Licht über eine außerhalb des Reflektorelements gelegene Leuchtdiode in das Reflektorelement einbringt. Ein Lichtleiter kann dabei ein flexibles oder starres, zum Beispiel blockartiges, Element sein. Solche Lichtleiter können sich bei einer Reflektorplatte über eine Vielzahl von Reflektorelementen erstrecken. D.h. eine Leuchtdiode kann bspw. eine Grundbeleuchtung für eine Vielzahl von "Schaltflächen" bereitstellen. Zusätzlich kann bei jeder Schaltfläche, Sensorelement, das über das Reflektorelement und den Lichtleiter beleuchtet wird, eine zusätzliche Leuchtdiode vorgesehen sein, die dann aktiv betrieben wird und Licht in einer einstellbaren Stärke und Farbe ausgibt, wenn die "Schaltfläche" betätigt wird und/oder ist. Hierdurch kann die Einrichtung kostengünstiger hergestellt und betrieben werden, da auch der Energieverbrauch reduziert ist.

In weiteren Ausführungen kann insbesondere auf eine Vielzahl an weißen LEDs verzichtet werden, wenn bspw. nur eine weiße LED benötigt wird, welche eine Standardbeleuchtung der Symbole und Zeichen über einen Lichtleiter bereitstellt, da weiße LEDs kostenintensiv sind. Eine Beleuchtung bei einer Aktivierung bzw. Betätigung einer Schaltfläche kann bspw. über eine Leuchtdiode erreicht werden, welche gelbes Licht ausgibt.

In noch weiteren Ausführungen kann mindestens eine lichtemittierende Diode Licht in verschiedenen Farben ausgeben.

Das mindestens eine Sensorelement kann in weiteren Ausführungen mit einem Element für eine haptische Rückmeldung, mit einem Element für eine optische Rückmeldung und/oder mit einem Element für eine akustische Rückmeldung gekoppelt sein. Eine haptische Rückmeldung kann bspw. über eine Vibration erfolgen. Damit durch Rückmeldungseinrichtungen keine Beeinträchtigung der Beleuchtung erfolgt, sind diese Einrichtungen vorzugsweise ebenfalls an der Leiterplatte angeordnet. Weiterhin ist neben einer optischen Rückmeldung durch eine Veränderung der Beleuchtung und einer haptischen Rückmeldung durch Vibration auch eine akustische Rückmeldung möglich. Die akustische Rückmeldung kann auch über eine Einrichtung erfolgen, welche lediglich signaltechnisch mit der Einrichtung gekoppelt und entfernt zu der Einrichtung angeordnet ist.

Die Blende kann insbesondere an ihrer Rückseite Verbindungselemente aufweisen, über welche die Blende austauschbar mit einem Gehäuse der Einrichtung verbindbar ist. Das Gehäuse kann dabei Aufnahmen aufweisen, in welche die Verbindungselemente einsetzbar sind. Bspw. weist das Gehäuse eine gummiartige Lage auf, welche Verbindungsabschnitte aufweist. In diese Verbindungsabschnitte können dann bspw. Verbindungselemente eingesteckt und somit mit dem Gehäuse verbunden werden.

In weiteren Ausführungen können auch die Leiterplatte sowie in weiteren Ausführungen eine Reflektorplatte austauschbar sein, so dass die Einrichtung an verschiedene Aufgaben anpassbar ist und auch als adaptionsfähiges Modul für verschiedene Einsatzgebiete verwendet werden kann.

Weitere Vorteile, Merkmale und Ausgestaltungen ergeben sich aus der nachfolgenden Figurenbeschreibung von nicht einschränkend zu verstehenden Ausführungsbeispielen.

In den Zeichnungen zeigt:
- Fig. 1: eine perspektivische Darstellung einer Einrichtung mit beleuchtbaren Bereichen und Schaltelementen;
- Fig. 2: eine perspektivische Darstellung der Einrichtung von Fig. 1 in einer Rückansicht;
- Fig. 3: eine schematische Draufsicht auf eine Blende der Einrichtung von Fig. 1;
- Fig. 4: eine perspektivische Darstellung der Blende von Fig. 1 in einer Rückansicht;
- Fig. 5: eine perspektivische Darstellung eines Gehäuses der Einrichtung von Fig. 1;
- Fig. 6: eine schematische Draufsicht auf eine elastische Lage der Einrichtung von Fig. 1;
- Fig. 7: eine schematische Draufsicht auf das Gehäuse mit der Lage für die Einrichtung von Fig. 1;
- Fig. 8: eine schematische Draufsicht auf eine Leiterplatte der Einrichtung von Fig. 1;
- Fig. 9: eine perspektivische Darstellung der Leiterplatte von Fig. 8;
- Fig. 10: eine schematische Draufsicht auf eine Reflektorplatte der Einrichtung von Fig. 1;
- Fig. 11: eine perspektivische Darstellung der Reflektorplatte von Fig. 10;
- Fig. 12: eine Explosionszeichnung der Einrichtung von Fig. 1;
- Fig. 13: eine weitere Explosionszeichnung der Einrichtung von Fig. 1; und
- Fig. 14: eine schematische Schnittansicht durch die Einrichtung von Fig. 1.

In den Figuren mit gleichen Bezugszeichen versehene Teile entsprechen im Wesentlichen einander, sofern nichts anderes angegeben ist. Darüber hinaus wird darauf verzichtet Bestandteile zu zeigen und zu beschreiben, welche nicht wesentlich zum Verständnis der hierin offenbarten technischen Lehre sind.

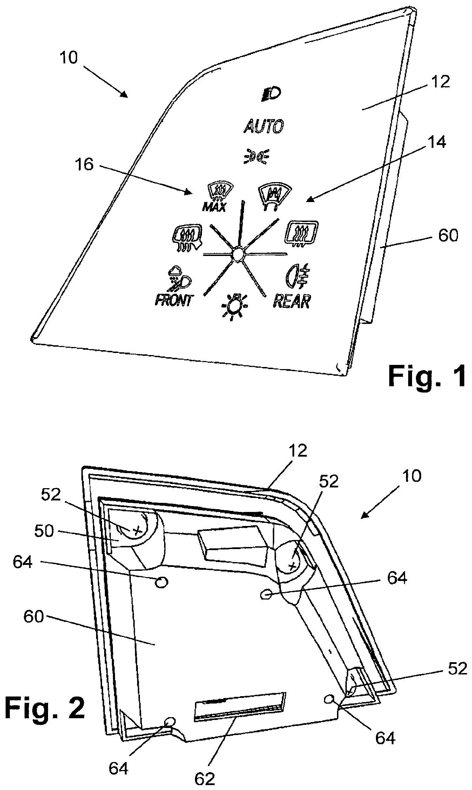

Fig. 1 zeigt eine perspektivische Darstellung einer Einrichtung 10 mit beleuchtbaren Bereichen 14 und Schaltelementen. Die Schaltelemente werden durch kapazitive Sensoren gebildet, die unter der Blende 12 an einer Leiterplatte 30 angeordnet sind. Die Einrichtung 10 kann beispielsweise in einem Kraftfahrzeug angeordnet sein. In weiteren nicht dargestellten Ausführungen können anstelle von kapazitiven Sensorelementen auch optische Sensorelemente oder Sensorelemente vorgesehen sein, die bspw. mit Ultraschall arbeiten.

Die Einrichtung 10 weist eine Blende 12 auf, welche die sichtbare Oberfläche der Einrichtung 10 bildet. Die Blende 12 besteht aus einem Kunststoff, der beleuchtbare Bereiche 14 aufweist. Die beleuchtbaren Bereiche 14 können verschiedenartig in die Blende 12 eingebracht werden. Beispielsweise wird die Blende 12 an ihrer Rückseite mit einer nicht lichtdurchlässigen Schicht versehen und diese Schicht in den Bereichen, welche später beleuchtet werden sollen, abgetragen. Die Blende 12 kann insbesondere in den beleuchtbaren Bereichen 14 so ausgebildet sein, dass die beleuchtbaren Bereiche 14 sich auch farblich unterscheiden. Ferner kann in den durchleuchtbaren Bereichen 14 auf die Blende 12 ein Symbol 16 oder ein Zeichen aufgedruckt sein. Insbesondere kann die Blende 12 so ausgebildet sein, dass die Symbole 16 oder Zeichen, welche repräsentativ für Funktionen sind, in der Blende 12 integriert oder teilweise, beispielsweise haptisch, wahrnehmbar (fühlbar) sind.

Fig. 2 zeigt eine perspektivische Darstellung der Einrichtung 10 von Fig. 1 in einer Rückansicht. In Fig. 2 ist das Gehäuse 60 dargestellt, über welches die Einrichtung 10 beispielsweise in einer Instrumententafel eines Fahrzeugs angeordnet werden kann. Die Blende 12 weist eine solche Oberflächenbeschaffenheit und Farbgebung auf, dass diese sich in das Armaturenbrett einfügt. Die Oberfläche der Blende 12 unterliegt hierbei im Wesentlichen keinen Einschränkungen, da die Schaltfunktion über kapazitive Sensorelemente bereitgestellt wird, die auf einer Leiterplatte 30 angeordnet sind. Das Gehäuse 60 weist Öffnungen 64 auf, über welche das Gehäuse 60 beispielsweise an einem Armaturenbrett aufgesteckt oder angeschraubt werden kann. Zusätzlich weist das Gehäuse 60 eine Öffnung 62 auf, über welche Versorgungs- und Kommunikationsleitungen hineingeführt werden. Die auf der Leiterplatte 30 angeordneten Schaltelemente und Steuereinheiten sind über diese Kommunikations- und Versorgungsleitungen mit einer zentralen Steuereinheit und einer Energieversorgungseinrichtung gekoppelt.

Das Gehäuse 60 ist ferner mit einer elastischen Lage 50 verbunden, welche Aufnahmen 52 aufweist. In diese Aufnahmen 52 können Rastknöpfe 20 der Blende 12 eingesteckt werden, worüber die Blende 12 austauschbar mit dem Gehäuse 60 verbunden wird.

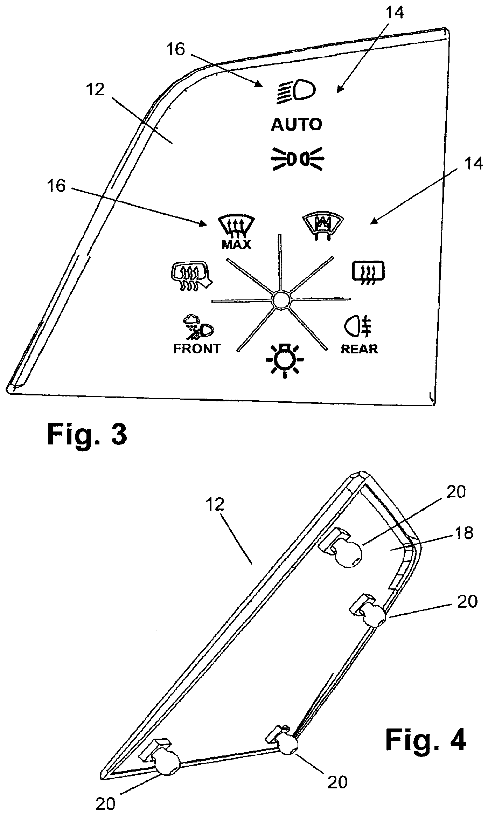

Fig. 3 zeigt eine schematische Draufsicht auf die Blende 12 der Einrichtung 10. Die Blende 12 weist beispielsweise verschiedene Symbole auf, die zur Ansteuerung der Fahrzeugbeleuchtung und zum Steuern von Heizelementen dienen. Die dargestellten Symbole 16 können auf der Blende 12 auch dann sichtbar sein, wenn das Fahrzeug nicht in Betrieb ist und damit keine Beleuchtung erfolgt. In weiteren Ausführungsformen können die Symbole 16 aber auch nur dann sichtbar sein, wenn diese beleuchtet werden. Wird die Einrichtung 10 nicht betrieben und damit die Blende 12 nicht beleuchtet, können die durchleuchtbaren Bereiche 14 das gleiche Erscheinungsbild aufweisen wie die restliche Blende 12.

Fig. 4 zeigt eine perspektivische Darstellung der Blende 12 in einer Rückansicht. Die Blende 12 weist an ihrer Rückseite 14 vier Rastknöpfe 20 auf. Die Rastknöpfe 20 werden in die Aufnahmen 52 der elastischen Lage 50 eingedrückt. Die elastische Lage 50 kann beispielsweise gummiartig ausgeführt sein.

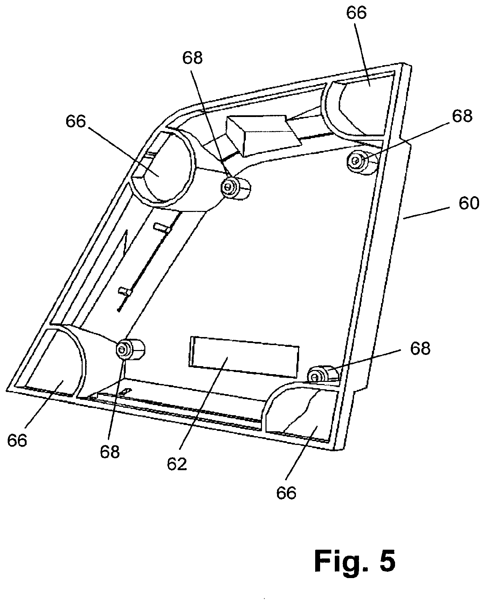

Fig. 5 zeigt eine perspektivische Darstellung eines Gehäuses 60 der Einrichtung 10. Das Gehäuse 60 weist Öffnungen 66 auf, in welchen die Rastknöpfe 20 im zusammengebauten Zustand der Einrichtung 10 aufgenommen sind. Das Gehäuse 60 weist zusätzlich Stifte 68 auf, welche nach hinten in die Öffnungen 64 münden und auch als Auflage für die Leiterplatte 30 dienen können.

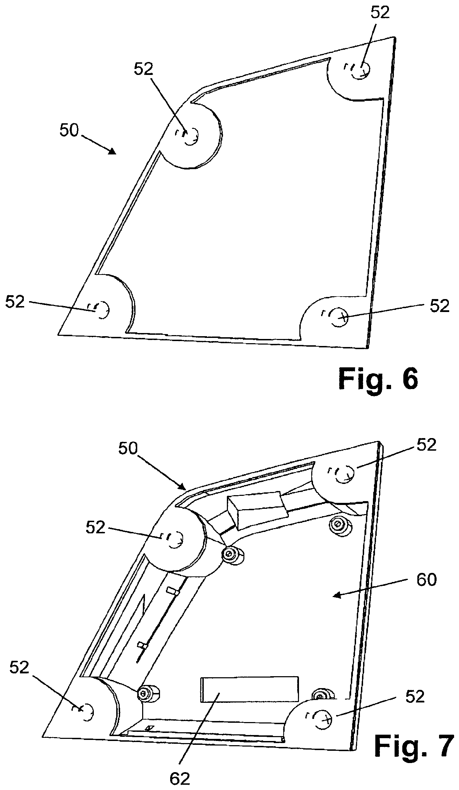

Fig. 6 zeigt eine schematische Draufsicht auf eine elastische Lage 50 der Einrichtung 10. Die Aufnahmen 52 sind so ausgebildet, dass die Rastknöpfe 20 sicher darin gehalten werden können. Zusätzlich können die Rastknöpfe 20 aber auch leicht aus den Aufnahmen 52 herausbewegt werden. Die Aufnahmen 52 können beispielsweise auch durch Öffnungen in einer flexiblen Schicht gebildet werden.

Fig. 7 zeigt eine schematische Draufsicht auf das Gehäuse 60 mit der Lage 50 für die Einrichtung 10. Die Lage 50 kann mit dem Gehäuse 60 verklebt werden, sodass die elastische Lage 50 fest mit dem Gehäuse 60 verbunden ist. Die Aufnahmen 52 befinden sich im Bereich der Öffnungen 66.

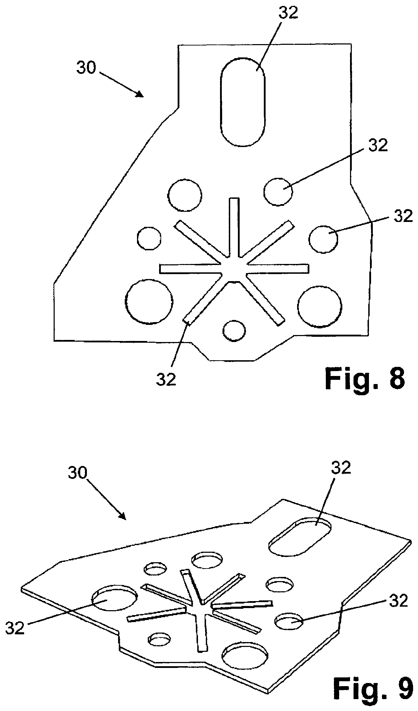

Fig. 8 zeigt eine schematische Draufsicht auf die Leiterplatte 30 der Einrichtung 10. Die Leiterplatte 30 weist eine Vielzahl von Öffnungen 32 auf. Die Öffnungen 32 befinden sich unterhalb der beleuchtbaren Bereiche 14 mit den Symbolen 16 der Blende 12. Die Öffnungen 32 geben damit vor, inwieweit eine Beleuchtung der Bereiche 14 erfolgt. Die Öffnungen 32 sind im Wesentlichen an die Symbole 16 angepasst.

Fig. 9 zeigt eine perspektivische Darstellung der Leiterplatte 30. An der Leiterplatte 30 sind an deren Oberseite kapazitive Sensoren angeordnet, welche in den Figuren aus Gründen der Übersichtlichkeit nicht dargestellt sind. Die Ausbildung von kapazitiven Sensoren ist aus dem Stand der Technik bekannt. Die kapazitiven Sensoren erstrecken sich vorzugsweise am Rand der Öffnungen 32. Die kapazitiven Sensoren können beispielsweise auch vollständig eine der Öffnungen 32 umgeben und/oder sich entlang eines Abschnitts erstrecken. Hierdurch ist es möglich, beispielsweise durch eine streichende Bewegung über die Oberfläche der Blende 12 eine korrespondierende Steuerung, beispielsweise zum Erhöhen einer Temperatur, durchzuführen. An der Leiterplatte 30 sind zudem Leuchtioden 34 angeordnet, welche sich an der Unterseite der Leiterplatte 30 befinden. Zusätzlich weist die Leiterplatte 30 noch weitere nicht dargestellte Verbindungen und Schaltelemente auf, die zur Bereitstellung der hierin beschriebenen Funktionen dienen. Ebenso weist die Leiterplatte 30 einen Anschluss auf, über den eine Energieversorgung und Kommunikation mit beispielsweise einer externen Steuereinrichtung durchgeführt wird. Diese Komponenten sind der Übersichtlichkeit halber nicht dargestellt.

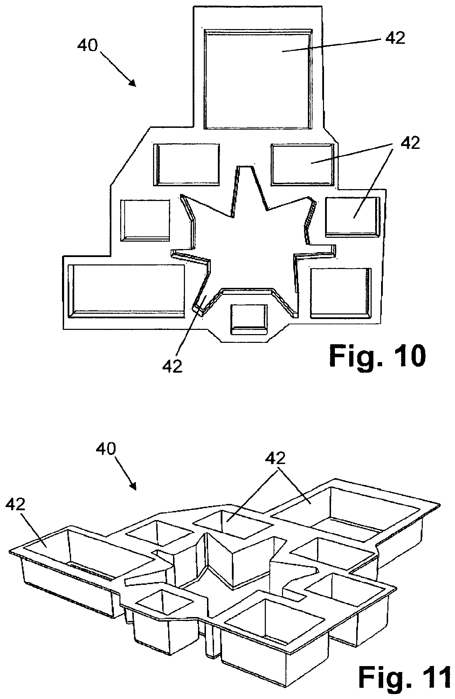

Fig. 10 zeigt eine schematische Draufsicht auf eine Reflektorplatte 40 der Einrichtung 10. Die Reflektorplatte 40 weist eine Vielzahl von Mulden 42 auf, die sich ebenfalls im Bereich der Öffnungen 32 der Leiterplatte 30 und der beleuchtbaren Bereiche 14 der Blende 12 befinden. Ebenso sind die Mulden 42 der Form und den Abmaßen der beleuchtbaren Bereiche 14 ausgebildet.

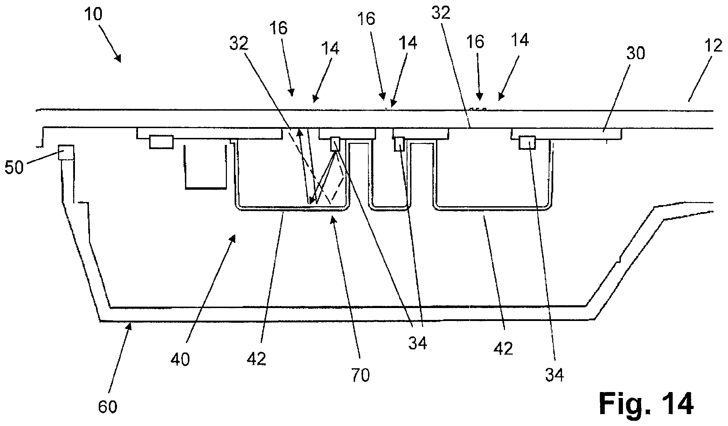

Fig. 11 zeigt eine perspektivische Darstellung der Reflektorplatte 40. Die Mulden 42 sind so ausgebildet, dass Licht, welches von den Leuchtioden 34 nach unten abgestrahlt wird, reflektiert und nach oben geleitet wird, sodass es durch die Öffnungen 32 zu dem beleuchtbaren Bereichen 14 gelangt (siehe Fig. 14). Die Reflektorplatte 40 kann beispielsweise aus einem Kunststoff in einem Spritzgussverfahren hergestellt werden. Anschließend können die Mulden 42 oder die gesamte Reflektorplatte 40 mit einer reflektierenden Schicht versehen werden. Dies kann durch verschiedene Verfahren erfolgen. In alternativen Ausführungsformen kann die Reflektorplatte 40 auch aus einem Metall gebildet werden. Die Abgrenzung der Mulden 42 ermöglicht es eine Beleuchtung der jeweiligen Bereiche 14 in Abhängigkeit der gewünschten Ansteuerung von Leuchtioden 34 durchzuführen. Es kommt damit nicht zu einer Beleuchtung von Symbolen 16, die nicht beleuchtet werden sollen. Die Mulden 42 dienen dabei auch zur Abschottung.

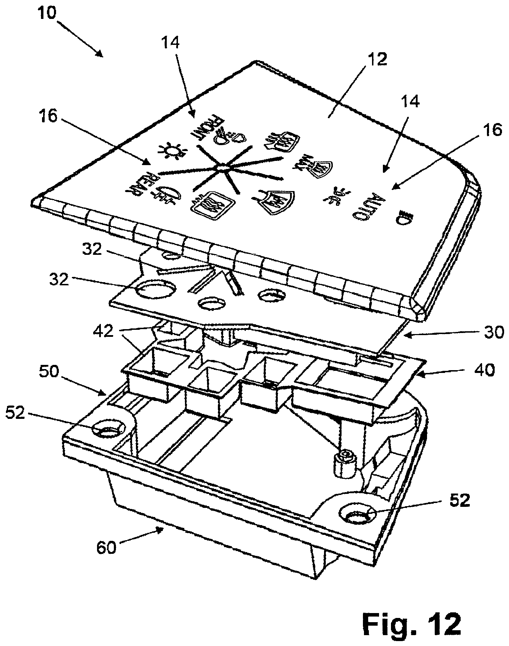

Fig. 12 zeigt eine Explosionszeichnung der Einrichtung 10. Die Komponenten der Einrichtung 10, nämlich die Blende 12, die Leiterplatte 30, die Reflektorplatte 40 und das Gehäuse 60 mit der elastischen Lage 50 werden übereinander angeordnet und miteinander verbunden. Durch die Anordnung der kapazitiven Schaltelemente auf der Leiterplatte 30 kann bei der Einrichtung 10 auf kapazitive Folien verzichtet werden. Aus dem Stand der Technik ist es bekannt, zur Ausbildung von kapazitiven Oberflächen Folien mit kapazitiven Sensoren beispielsweise auf eine Blende aufzubringen. Dieser Bearbeitungsschritt erfordert neben dem zusätzlichen Bereitstellen der Folie und dem Zeitaufwand ein exaktes Ausrichten der Folie. Zudem kann eine zusätzliche Klebeschicht erforderlich sein. Bei der hierin beschriebenen Einrichtung 10 sind die wesentlichen Komponenten zur Beleuchtung und zur Erfassung von Bedienbefehlen direkt an der Leiterplatte 30 angeordnet, sodass auf ein exaktes Ausrichten/Positionieren verzichtet werden kann. Zudem kann die Einrichtung 10 einfach zusammengebaut werden. Die Ausrichtung der einzelnen Komponenten kann durch entsprechende Ausgestaltung dieser zueinander festgelegt werden.

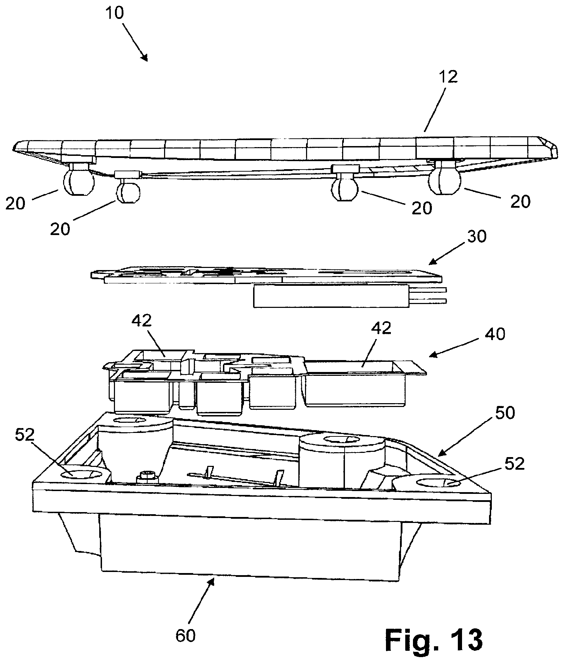

Fig. 13 zeigt eine weitere Explosionszeichnung der Einrichtung 10.

Fig. 14 zeigt schließlich eine schematische Schnittansicht durch die Einrichtung 10. Wie in den Fig. 12 und 13 gezeigt, ist der Aufbau derart, dass auf das Gehäuse 60 die Lage 50 aufgebracht wird. Die Reflektorplatte 40 ist ferner so zu deren Leiterplatte 30 angeordnet, dass die einzelnen Mulden 42 die Öffnungen 32 in der Leiterplatte 30 umgeben und gegenüber angrenzenden Öffnungen 32 abschotten. Die Leiterplatte 30 ist ferner direkt an der Blende 12 angeordnet, wobei sich die Öffnungen 32 unterhalb der beleuchtbaren Bereiche 14 befinden.

Die Leuchtioden 34 sind so angeordnet, dass diese nicht in die Öffnungen 32 ragen und damit die Beleuchtung der Bereiche 14 nicht behindern. Im Betrieb der Leuchtioden 34 strahlen diese Licht in verschiedene Richtungen ab. Die Strahlen 70 werden an den Innenwänden der Mulden 42 reflektiert und gelangen schließlich zu den Öffnungen 32. Die Beleuchtung der Bereiche 34 erfolgt daher nur durch die Öffnungen 32, wobei aufgrund der Reflektion der Lichtstrahlen 70 eine homogene Beleuchtung der Symbole 16 durch eine Ausleuchtung der Bereiche 14 erreicht wird. Die Gestaltung der Mulden 42 ist maßgeblich für die Beleuchtung, wobei die Lichtstrahlen 70 auch anders als in den Figuren gezeigt umgelenkt werden können. Hierüber ist es möglich, vor allem bei beleuchtbaren Bereichen 14, die sich über eine bestimmte Strecke entlang der Blende 12 erstrecken, eine abnehmende oder zunehmende Beleuchtung zu realisieren. Dies kann beispielsweise durch einen schräg verlaufenden Boden der Mulden 42 erreicht werden.

Es können auch "lichtdämpfende" Elemente in Mulden 42 eingebracht werden. Bspw. kann auf den Boden einer Mulde 42 mittig ein Stoff, z.B. ein Schaumstoff, eingesetzt und aufgeklebt werden. Der Schaumstoff erstreckt sich nicht über die gesamte Bodenfläche der Mulde 42. Wird die Mulde 42 über ihre zugehörige Leuchtdiode 34 beleuchtet, reflektiert der Bereich des Bodens der Mulde 42 mit dem Schaumstoff kein Licht. Hierdurch kann bspw. eine ringförmige Beleuchtung des Bereichs 14 erreicht werden.

Die kapazitiven Elemente auf der Leiterplatte 30 sind so angeordnet, dass diese nicht in die Öffnungen 32 beziehungsweise in den beleuchtbaren Bereich 14 ragen. Eine kapazitive Änderung kann auch dann erfasst werden, wenn sich beispielsweise der Finger einer Person in der Nähe der kapazitiven Elemente befindet. Darüber hinaus können die Öffnungen 32 derart gewählt werden, dass diese beispielsweise geringer sind als die Breite eines Fingers.

### Bezugszeichenliste

- 10: Einrichtung
- 12: Blende
- 14: Bereich
- 16: Symbole
- 18: Rückseite
- 20: Rastknopf
- 30: Leiterplatte
- 32: Öffnung
- 34: Leuchtdiode
- 40: Reflektorplatte
- 42: Mulde
- 50: elastische Lage
- 52: Aufnahme
- 60: Gehäuse
- 62: Öffnung
- 64: Öffnung
- 66: Öffnung
- 68: Stift
- 70: Lichtstrahlen

## Patentansprüche

1. Einrichtung mit mindestens einem beleuchtbaren Bereich (14) und einer Bedieneinrichtung, aufweisend eine Blende (12), eine Leiterplatte (30), mindestens ein Leuchtmittel und mindestens ein Reflektorelement, wobei
- die Blende (12) mindestens einen beleuchtbaren Bereich (14) aufweist,
- die Leiterplatte (30) mindestens ein Leuchtmittel aufweist, das benachbart zu einer Öffnung (32) in der Leiterplatte (30) angeordnet ist,
- die Blende (12) so zu der Leiterplatte (30) angeordnet ist, dass der mindestens eine beleuchtbare Bereich (14) über einer Öffnung (32) in der Leiterplatte (30) angeordnet ist,
- das mindestens eine Leuchtmittel an der der Blende (12) abgewandten Seite an der Leiterplatte (30) angeordnet ist,
- ein Reflektorelement derart angeordnet ist, dass das von dem mindestens einen Leuchtmittel ausgegebene Licht zu der Öffnung (32) und dem darüber liegenden beleuchtbaren Bereich (14) reflektiert wird,
- die Bedieneinrichtung mindestens ein in der Leiterplatte (30) integriertes Sensorelement aufweist,
- die Einrichtung eine Reflektorplatte (40) mit mehreren Reflektorelementen aufweist, die durch Vertiefungen in der Reflektorplatte (40) gebildet sind, und
- sich Form und Abmaße mindestens zweier Reflektorelemente unterscheiden.

2. Einrichtung nach Anspruch 1, wobei das mindestens eine Reflektorelement so ausgebildet ist, dass es einen Boden und den Boden umgebende Seitenwände aufweist, wobei die oberen Enden der Seitenwände an der Leiterplatte (30) anliegen.

3. Einrichtung nach Anspruch 2, wobei die oberen Seitenwände des mindestens einen Reflektorelements die mindestens eine Öffnung (32) in der Leiterplatte (30) und mindestens das mindestens eine der Öffnung (32) zugehörige Leuchtmittel umgeben.

4. Einrichtung nach einem der Ansprüche 1 bis 3, wobei das mindestens eine Reflektorelement aus einem reflektierenden Material besteht und/oder eine reflektierende Oberfläche und/oder eine reflektierende Beschichtung aufweist.

5. Einrichtung nach einem der Ansprüche 1 bis 4, wobei der mindestens eine beleuchtbare Bereich (14) ein Symbol oder Zeichen aufweist.

6. Einrichtung nach einem der Ansprüche 1 bis 5, wobei das mindestens eine Reflektorelement oder die Reflektorplatte (40) aus Kunststoff oder Metall bestehen.

7. Einrichtung nach einem der Ansprüche 1 bis 6, wobei das mindestens eine Reflektorelement im Wesentlichen schalenförmig, topfförmig, wannenförmig oder rinnenförmig ausgebildet ist.

8. Einrichtung nach einem der Ansprüche 1 bis 7, wobei das mindestens eine Sensorelement im Bereich einer Öffnung (32) angeordnet ist.

9. Einrichtung nach einem der Ansprüche 1 bis 8, wobei das Leuchtmittel eine lichtemittierende Diode und/oder ein Leuchtkörper ist.

10. Einrichtung nach einem der Ansprüche 1 bis 9, wobei das mindestens eine Sensorelement mit einem Element für eine haptische Rückmeldung, mit einem Element für eine optische Rückmeldung und/oder mit einem Element für eine akustische Rückmeldung gekoppelt ist.

11. Einrichtung nach einem der Ansprüche 1 bis 10, wobei die Blende (12) Verbindungselemente aufweist, über welche die Blende (12) austauschbar mit einem Gehäuse (60) der Einrichtung (10) verbindbar ist.

## Claims

1. Device with at least one illuminatable region (14) and a control device, comprising a panel (12), a circuitboard (30), at least one lighting means and at least one reflector element, wherein
- the panel (12) has at least one illuminatable region (14),
- the circuitboard (30) has at least one lighting means, which is arranged adjacent to an opening (32) in the circuitboard (30),
- the panel (12) is so arranged with respect to the circuitboard (30) that the at least one illuminatable region (14) is arranged over an opening (32) in the circuitboard (30),
- the at least one lighting means is arranged at the circuitboard (30) at the side remote from the panel (12),
- a reflector element is arranged in such a way that the light, which is output by the at least one lighting means, is reflected towards the opening (32) and the illuminatable region (14) lying thereover,
- the control device comprises at least one sensor element integrated in the circuitboard (30),
- the device comprises a reflector plate (40) with a plurality of reflector elements, which are formed by recesses in the reflector plate (40), and
- the shape and size of at least two reflector elements differ.

2. Device according to claim 1, wherein the at least one reflector element is so constructed that it has a base and side walls surrounding the base, wherein the upper ends of the side walls bear against the circuitboard (30).

3. Device according to claim 2, wherein the upper side walls of the at least one reflector element surround the at least one opening (32) in the circuitboard (30) and at least the lighting means belonging to the at least one opening (32).

4. Device according to any one of claims 1 to 3, wherein the at least one reflector element consists of a reflective material and/or has a reflective surface and/or a reflective coating.

5. Device according to any one of claims 1 to 4, wherein the at least one illuminatable region (14) has a symbol or marking.

6. Device according to any one of claims 1 to 5, wherein the at least one reflector element or the reflector plate (40) consists of plastics material or metal.

7. Device according to any one of claims 1 to 6, wherein the at least one reflector element is constructed to be substantially bowl-shaped, pot-shaped, trough-shaped or channel-shaped.

8. Device according to any one of claims 1 to 7, wherein the at least one sensor element is arranged in the region of an opening (32).

9. Device according to any one of claims 1 to 8, wherein the lighting means is a light-emitting diode and/or a lighting body.

10. Device according to any one of claims 1 to 9, wherein the at least one sensor element is coupled with an element for a haptic feedback, with an element for an optical feedback and/or with an element for an acoustic feedback.

11. Device according to any one of claims 1 to 10, wherein the panel (12) comprises connecting elements by way of which the panel (12) is exchangeably connectible with a housing (60) of the device (10).

## Revendications

1. Dispositif avec au moins une zone pouvant être éclairée (14) et un dispositif de commande, comprenant un panneau (12), une carte de circuit imprimé (30), au moins un moyen d'éclairage et au moins un élément de réflecteur, dans lequel
- le panneau (12) comprend au moins une zone pouvant être éclairée (14),
- la carte de circuit imprimé (30) comprend au moins un moyen d'éclairage, qui est disposé au voisinage d'une ouverture (32) dans la carte de circuit imprimé (30),
- le panneau (12) est disposé par rapport à la carte de circuit imprimé (30) de sorte que l'au moins une zone pouvant être éclairée (14) est disposée au-dessus d'une ouverture (32) dans la carte de circuit imprimé (30),
- l'au moins un moyen d'éclairage est disposé du côté, opposé au panneau (12), de la carte de circuit imprimé (30),
- un élément de réflecteur est disposé de sorte que la lumière émise par l'au moins un moyen d'éclairage est réfléchie vers l'ouverture (32) et vers la zone pouvant être éclairée (14) située au-dessus de l'ouverture,
- le dispositif de commande comprend au moins un élément de capteur intégré dans la carte de circuit imprimé (30),
- le dispositif comprend une plaque de réflecteur (40) avec plusieurs éléments de réflecteur qui sont formés par des évidements dans la plaque de réflecteur (40), et
- la forme et les dimensions d'au moins deux éléments de réflecteur se différencient.

2. Dispositif selon la revendication 1, dans lequel l'au moins un élément de réflecteur est conçu de sorte qu'il comprend un fond et des parois latérales entourant le fond, dans lequel les extrémités supérieures des parois latérales reposent contre la carte de circuit imprimé (30).

3. Dispositif selon la revendication 2, dans lequel les parois latérales supérieures de l'au moins un élément de réflecteur entourent l'au moins une ouverture (32) dans la carte de circuit imprimé (30) et au moins l'au moins un moyen d'éclairage associé à l'ouverture (32).

4. Dispositif selon l'une quelconque des revendications 1 à 3, dans lequel l'au moins un élément de réflecteur se compose d'un matériau réfléchissant et/ou comprend une surface réfléchissante et/ou un revêtement réfléchissant.

5. Dispositif selon l'une quelconque des revendications 1 à 4, dans lequel l'au moins une zone pouvant être éclairée (14) comprend un symbole ou un caractère.

6. Dispositif selon l'une quelconque des revendications 1 à 5, dans lequel l'au moins un élément de réflecteur ou la plaque de réflecteur (40) se compose de matière synthétique ou de métal.

7. Dispositif selon l'une quelconque des revendications 1 à 6, dans lequel l'au moins un élément de réflecteur est conçu sensiblement avec une forme de coupe, de pot, de cuve ou de gouttière.

8. Dispositif selon l'une quelconque des revendications 1 à 7, dans lequel l'au moins un élément de capteur est disposé dans la zone d'une ouverture (32).

9. Dispositif selon l'une quelconque des revendications 1 à 8, dans lequel le moyen d'éclairage est une diode électroluminescente et/ou un corps lumineux.

10. Dispositif selon l'une quelconque des revendications 1 à 9, dans lequel l'au moins un élément de capteur est couplé à un élément pour un rétrosignal haptique, à un élément pour un rétrosignal optique et/ou à un élément pour un rétrosignal acoustique.

11. Dispositif selon l'une quelconque des revendications 1 à 10, dans lequel le panneau (12) comprend des éléments de liaison par le biais desquels le panneau (12) est relié de manière remplaçable à un boîtier (60) du dispositif (10).
